# EUROPEAN PATENT APPLICATION

(11) **EP 3 705 943 A1**
(43) Date of publication of application: **09.09.2020**
(21) Application number: 19193245.8
(22) Date of filing: 23.08.2019
(51) Int. Cl.: G03F 1/66, G03F 7/20, H01L 21/673, B65D 85/48

(54) **POD FOR HOUSING PATTERNING DEVICE**

(71) Applicant: ASML Netherlands B.V., 5500 AH Veldhoven (NL)
(72) Inventor: VAN DE KERKHOF, Marcus Adrianus, 5500 AH Veldhoven (NL)
(74) Representative: ASML Netherlands B.V.

(57) **Abstract**

A pod for housing a patterning device for EUV lithography, the pod comprising: a top member and an opposing bottom member each comprising a metal main body and a closing surface configured to contact the closing surface of the other member so as to close the pod around a patterning device, wherein the closing surface of one of the members is formed by a non-metal sealer configured to conform to the closing surface of the other member.

## Description

### FIELD

The present invention relates to a pod for housing a patterning device and to a method of manufacturing the pod. The present invention has particular, but not exclusive, use in connection with EUV lithographic apparatus and EUV lithographic tools.

### BACKGROUND

A lithographic apparatus is a machine constructed to apply a desired pattern onto a substrate. A lithographic apparatus can be used, for example, in the manufacture of integrated circuits (ICs). A lithographic apparatus may for example project a pattern from a patterning device (e.g., a mask) onto a layer of radiation-sensitive material (resist) provided on a substrate.

The wavelength of radiation used by a lithographic apparatus to project a pattern onto a substrate determines the minimum size of features that can be formed on that substrate. A lithographic apparatus that uses EUV radiation, that is electromagnetic radiation having a wavelength within the range 4-20 nm, may be used to form smaller features on a substrate than a lithographic apparatus using DUV radiation (for example with a wavelength of 193 nm).

The beam path, including the mask and substrate, in a lithographic apparatus using EUV is kept at a very low pressure in order to minimise the absorption of the EUV radiation. Such a lithographic apparatus is often referred to as being "in vacuum" but there may well be a low pressure of hydrogen in order to control contamination.

The patterning device can be housed inside a pod to protect it, for example while in storage, in transportation or inside the lithographic apparatus. The pod needs to be opened and closed to provide access to the patterning device. Opening and closing of the pod can lead to wear and undesirable formation of particles. Such particles can reduce the accuracy of the projected pattern. Motion between the parts of the pod can undesirably create particles that might move towards the patterning device. This can happen, for example, due to earthquakes, or when gas flows into or out of the pod during a pressure change.

### SUMMARY

It is desirable to provide a pod that has a lower possibility of undesirably creating particles.

According to a first aspect of the invention there is provided a pod for housing a patterning device for EUV lithography, the pod comprising: a top member and an opposing bottom member each comprising a main body of a first material and a closing surface configured to contact the closing surface of the other member so as to close the pod around a patterning device, wherein the closing surface of one of the members is formed by a sealer of a second material different from the first material and configured to conform to the closing surface of the other member.

According to a second aspect of the invention there is provided a method of manufacturing a pod for housing a patterning device for EUV lithography, the method comprising: providing a top member and an opposing bottom member each comprising a main body of a first material and a closing surface configured to contact the closing surface of the other member so as to close the pod around a patterning device, wherein the closing surface of one of the members is formed by a sealer of a second material different from the first material configured to conform to the closing surface of the other member.

Features of different aspects of the invention may be combined with features of other aspects of the invention.

### BRIEF DESCRIPTION OF THE DRAWINGS

Embodiments of the invention will now be described, by way of example only, with reference to the accompanying schematic drawings, in which:
Figure 1 is a schematic illustration of a lithographic system comprising a lithographic apparatus and a radiation source;
Figure 2 is a schematic illustration of a pod for housing a patterning device according to an embodiment of the invention;
Figure 3 is a close-up of the top member of a pod according to an embodiment of the invention;
Figure 4 is a close-up of the top member of the pod according to an embodiment of the invention;
Figure 5 is a schematic illustration of part of a pod according to an embodiment of the invention; and
Figure 6 is an illustration of a transport case for a patterning device according to an embodiment of the invention.

### DETAILED DESCRIPTION

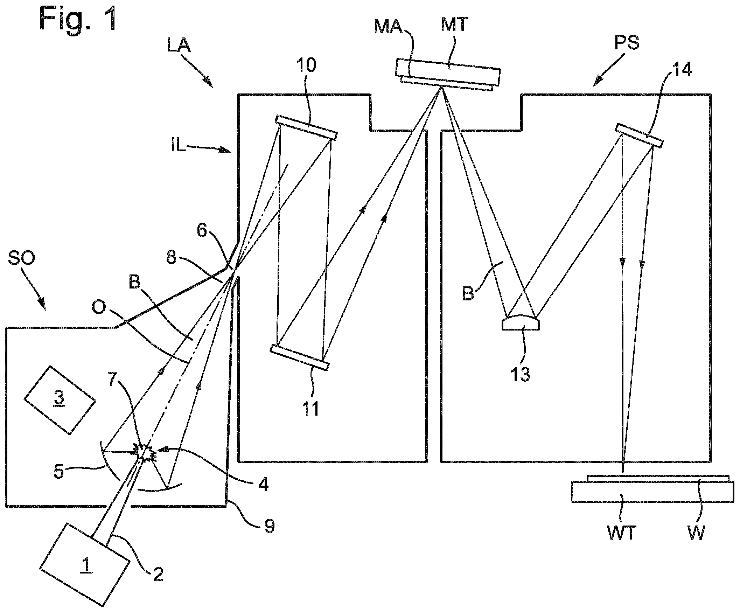

Figure 1 is a schematic illustration of a lithographic system. The lithographic system comprises a radiation source SO and a lithographic apparatus LA. The radiation source SO is configured to generate an extreme ultraviolet (EUV) radiation beam B. The lithographic apparatus LA comprises an illumination system IL, a support structure MT configured to support a patterning device MA, a projection system PS and a substrate table WT configured to support a substrate W. The illumination system IL is configured to condition the radiation beam B before it is incident upon the patterning device MA. The projection system is configured to project the radiation beam B (now patterned by the patterning device MA) onto the substrate W. The substrate W may include previously formed patterns. Where this is the case, the lithographic apparatus aligns the patterned radiation beam B with a pattern previously formed on the substrate W.

The radiation source SO, illumination system IL, and projection system PS may all be constructed and arranged such that they can be isolated from the external environment. A gas at a pressure below atmospheric pressure (e.g. hydrogen) may be provided in the radiation source SO. A vacuum may be provided in the illumination system IL and/or the projection system PS. A small amount of gas (e.g. hydrogen) at a pressure well below atmospheric pressure may be provided in the illumination system IL and/or the projection system PS.

The radiation source SO shown in Figure 1 is of a type that may be referred to as a laser produced plasma (LPP) source. A source laser 1, which may for example be a CO₂ laser, is arranged to deposit energy via a laser beam 2 into a fuel, such as tin (Sn) that is provided from a fuel emitter 3. Although tin is referred to in the following description, any suitable fuel may be used. The fuel may for example be in liquid form, and may for example be a metal or alloy. The fuel emitter 3 may comprise a nozzle configured to direct tin, for example, in the form of droplets, along a trajectory towards a plasma formation region 4. The laser beam 2 is incident upon the tin at the plasma formation region 4. The deposition of laser energy into the tin creates a plasma 7 at the plasma formation region 4. Radiation, including EUV radiation, is emitted from the plasma 7 during de-excitation and recombination of ions of the plasma.

The EUV radiation is collected and focused by a near normal incidence radiation collector 5 (sometimes referred to more generally as a normal incidence radiation collector). The collector 5 may have a multilayer structure that is arranged to reflect EUV radiation (e.g. EUV radiation having a desired wavelength such as 13.5 nm). The collector 5 may have an elliptical configuration, having two ellipse focal points. A first focal point may be at the plasma formation region 4, and a second focal point may be at an intermediate focus 6, as discussed below.

In other embodiments of a laser produced plasma (LPP) source the collector 5 may be a so-called grazing incidence collector that is configured to receive EUV radiation at grazing incidence angles and focus the EUV radiation at an intermediate focus. A grazing incidence collector may, for example, be a nested collector, comprising a plurality of grazing incidence reflectors. The grazing incidence reflectors may be disposed axially symmetrically around an optical axis O.

The radiation source SO may include one or more contamination traps (not shown). For example, a contamination trap may be located between the plasma formation region 4 and the radiation collector 5. The contamination trap may for example be a rotating foil trap, or may be any other suitable form of contamination trap.

The source laser 1 may be separated from the radiation source SO. Where this is the case, the laser beam 2 may be passed from the source laser 1 to the radiation source SO with the aid of a beam delivery system (not shown) comprising, for example, suitable directing mirrors and/or a beam expander, and/or other optics. The source laser 1 and the radiation source SO may together be considered to be a radiation system.

Radiation that is reflected by the collector 5 forms a radiation beam B. The radiation beam B is focused at point 6 to form an image of the plasma formation region 4, which acts as a virtual radiation source for the illumination system IL. The point 6 at which the radiation beam B is focused may be referred to as the intermediate focus. The radiation source SO is arranged such that the intermediate focus 6 is located at or near to an opening 8 in an enclosing structure 9 of the radiation source.

The radiation beam B passes from the radiation source SO into the illumination system IL, which is configured to condition the radiation beam. The illumination system IL may include a facetted field mirror device 10 and a facetted pupil mirror device 11. The faceted field mirror device 10 and faceted pupil mirror device 11 together provide the radiation beam B with a desired cross-sectional shape and a desired angular distribution. The radiation beam B passes from the illumination system IL and is incident upon the patterning device MA held by the support structure MT. The patterning device MA (which may for example be a mask) reflects and patterns the radiation beam B. The illumination system IL may include other mirrors or devices in addition to or instead of the faceted field mirror device 10 and faceted pupil mirror device 11.

Following reflection from the patterning device MA the patterned radiation beam B enters the projection system PS. The projection system comprises a plurality of mirrors 13, 14 that are configured to project the radiation beam B onto a substrate W held by the substrate table WT. The mirrors 13, 14 which form the projection system may be configured as reflective lens elements. The projection system PS may apply a reduction factor to the radiation beam, forming an image with features that are smaller than corresponding features on the patterning device MA. A reduction factor of 4 may for example be applied. Although the projection system PS has two mirrors 13, 14 in Figure 1, the projection system may include any number of mirrors (e.g. six mirrors).

The lithographic apparatus may, for example, be used in a scan mode, wherein the support structure (e.g. mask table) MT and the substrate table WT are scanned synchronously while a pattern imparted to the radiation beam is projected onto a substrate W (i.e. a dynamic exposure). The velocity and direction of the substrate table WT relative to the support structure (e.g. mask table) MT may be determined by the demagnification and image reversal characteristics of the projection system PS. The patterned radiation beam that is incident upon the substrate W may comprise a band of radiation. The band of radiation may be referred to as an exposure slit. During a scanning exposure, the movement of the substrate table WT and the support structure MT may be such that the exposure slit travels over an exposure field of the substrate W.

The radiation source SO and/or the lithographic apparatus that is shown in Figure 1 may include components that are not illustrated. For example, a spectral filter may be provided in the radiation source SO. The spectral filter may be substantially transmissive for EUV radiation but substantially blocking for other wavelengths of radiation such as infrared radiation.

In other embodiments of a lithographic system the radiation source SO may take other forms. For example, in alternative embodiments the radiation source SO may comprise one or more free electron lasers. The one or more free electron lasers may be configured to emit EUV radiation that may be provided to one or more lithographic apparatuses.

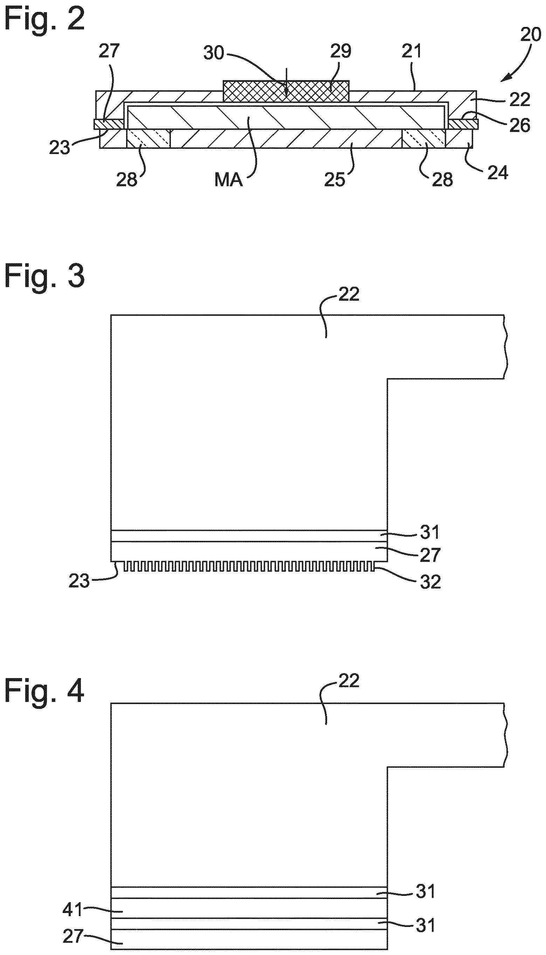

Figure 2 is a schematic illustration of a pod 20 according to an embodiment of the invention. The pod 20 is for housing a patterning device MA. In an embodiment the patterning device MA is for EUV lithography. The pod 20 houses the patterning device MA in a library, which may be kept at vacuum pressure, in the lithographic apparatus. For exposures, the pod 20 is opened and the patterning device MA is clamped into position.

As shown in Figure 2, in an embodiment the pod 20 comprises a top member 21 and an opposing bottom member 24. The top member 21 comprises a main body 22 of a first material. The top member 21 comprises a closing surface 23. The bottom member 24 comprises a main body 25 of the first material. The bottom member 24 comprises a closing surface 26.

The closing surfaces 23 and 26 are configured to contact each other so as to close the pod 20. For example, the pod 20 may be closed around a patterning device MA housed in the pod 20. Of course, the pod 20 can be closed regardless of whether or not a patterning device MA is housed in the pod 20.

The shape of the top member 21 and the bottom member 24 is not particularly limited. As shown in Figure 2, the top member 21 and/or the bottom member 24 may take the shape of a plate, being mainly flat. As shown in Figure 2, in an embodiment the top member 21 comprises a recess in which the patterning device MA can be placed. The recess is defined by a protrusion that extends around the patterning device MA. The closing surface 23 is at the end of the protrusion. As shown in Figure 2, in an embodiment the bottom member 24 may be substantially flat without any protrusion.

In an alternative embodiment, the recess and protrusion may be provided on the bottom member 24. In such an embodiment, the top member 21 may be substantially flat without any protrusion. In a further alternative embodiment, the recess and associated- protrusion may be provided by each of the top member 21 and the bottom member 24.

In an embodiment, the shape, in plan view, of the top member 21 matches the shape in plan view, of the bottom member 24. In an embodiment, the shape, in plan view, of the top member 21 matches the shape, in plan view, of the patterning device MA. For example, in an embodiment the patterning device MA is a square or rectangle. The top member 21 may be square or rectangle so as to house the patterning device MA without much space between the edges of the patterning device MA and the edges of the top member 21.

In an embodiment, the closing surfaces 23 and 26 make full contact around the edges of the top member 21 and the bottom member 24. The contact between the closing surfaces 23 and 26 forms a closed box.

The main bodies 22 and 25 are made of a first material. In an embodiment the first material is metal. However, other materials such as polycarbonate may be used as the first material, particularly if they are rigid and have low outgassing. The description below focuses on the example of metal as the first material, merely for conciseness.

Metal has low outgassing, so as to keep outgassing of particles to a minimum. The type of metal used is not particularly limited. In an embodiment, the metal is selected from a group consisting of aluminium and steel. In an embodiment, the metal is attracted to a magnet. This allows a magnet to help keep the pod 20 closed, as will be described in more detail below. In an embodiment, the metal of the main body 22 of the top member 21 is the same as the metal that forms the main body 25 of the bottom member 24. However, this is not necessarily the case. In an alternative embodiment, the main body 22 of the top member 21 is made from a different metal from the metal used for the main body 25 of the bottom member 24.

In an embodiment the pod 20 is configured to protect the patterning device MA while inside the lithographic apparatus. The pod 20 can be opened or closed by separating or bringing together the closing surfaces 23 and 26. The pod 20 may be opened, for example, to provide access to the patterning device MA. For example, it may be desirable to replace the patterning device MA with a different patterning device (for forming a different pattern, eg for a different layer of a device).

As shown in Figure 2, in an embodiment the pod 20 comprises a sealer 27. The sealer 27 is made of a second material different from the first material. In an embodiment in which the first material is metal, the second material is non-metal. The description below focuses on such an embodiment, merely for conciseness. As shown in Figure 2, in an embodiment the closing surface 23 of one of the members 21 is formed by the non-metal sealer 27. In the embodiment shown in Figure 2, the sealer 27 is positioned at the end of the protrusion that defines the recess in which the patterning device MA is placed. The bottom surface (in the orientation shown in Figure 2) of the sealer 27 forms the closing surface 23. It is not essential for the sealer 27 to be provided to the top member 21. In an alternative embodiment, the sealer 27 is provided to the bottom member 24. In a further alternative embodiment, a non-metal sealer 27 may be provided to each of the top member 21 and the bottom number 24.

In an embodiment, the sealer 27 is configured to conform to the closing surface 26 of the other member 24. In the example shown in Figure 2, the sealer 27 is configured to conform to the closing surface 26 of the bottom member 24. The sealer 27 has a softness that allows its shape to conform to any unevenness in the closing surface 26 of the bottom member 24. This improves gastightness of the closed pod 20 compared to if the sealer 27 were not provided. If the sealer 27 were not provided, then both closing surfaces 23 and 26 would be metal, neither being able to conform to the shape of the other. This means that any unevenness in the closing surfaces 23 and 26 would create holes through which gas could pass between the interior of the pod 20 and the exterior of the pod 20. An embodiment of the invention is expected to improve the gastightness of the pod 20.

Particles can form due to wear when the pod 20 is opened and closed if the closing surfaces 23 and 26 are both metal. By providing that the sealer 27 is non-metal, the situation of metal moving against metal when the pod 20 is opened or closed is avoided. An embodiment of the invention is expected to reduce particle formation.

By improving the gastightness, gas flow between the top member 21 and the bottom member 24 can be reduced. Such gas flow can occur, for example, when venting, e.g. when moving the pod 20 from a vacuum (or near vacuum) to a higher pressure (e.g. atmospheric pressure). By reducing the gas flow between the top member 21 and the bottom member 24, possible motion between the closing surfaces 23 and 26 can be reduced. This reduces the possibility of particles being created that could otherwise move towards the patterning device MA. Any particles that move towards the patterning device MA may undesirably reduce the accuracy of projecting the pattern from the patterning device MA.

When the patterning device MA is not required to be used in the lithographic apparatus, it can be stored, for example in what may be called a library. When the patterning device MA is stored in the pod 20, it is possible for the pod 20 to undergo vibrations, for example, during earthquakes. Such vibrations can potentially cause the top member 21 to move relative to the bottom member 24. An embodiment of the invention is expected to reduce the production of particles caused by this relative movement. The non-metal sealer 27 reduces the relative movement between the top member 21 and the bottom member 24. Such particles can potentially be transported towards the patterning device MA, particularly during venting.

In an embodiment, the sealer 27 comprises a ribbon of material attached to the main body 22 of the member 21. The sealer 27 may be formed from a foil or a tape, for example, attached to the main body 22. The material has a softness so that it can conform to the shape of the closing surface 26.

In an embodiment the sealer 27 is detachable to the main body 22. The sealer 27 can be treated as a consumable. It can be removed and reapplied, for example, during regular cleaning of the pod 20. The thickness of the ribbon is not particularly limited. For example, in an embodiment the feeder has a thickness of at most 100 µm, optionally at most 50 µm, optionally at most 20 µm and optionally about 10µm.

In an embodiment, the closing surface 23 formed by the sealer 27 is formed of a polymer. The sealer 27 may comprise a polymer. The type of polymer is not particularly limited. It is desirable for the polymer to have relatively low outgassing so as to reduce the creation of undesirable particles. In an embodiment, the polymer is selected from a group consisting of polyimide (e.g. Kapton), PTFE and silicone. Other polymers may be used. In an embodiment the sealer 27 comprises a diamond-like carbon (DLC) coating that forms the closing surface 23. For example, the sealer 27 may be a DLC coated tape.

In an embodiment the sealer 27 is configured such that a force resists movement between members 21 and 24 when the pod 20 is closed. For example, the conforming of the closing surface 23 to bumps in the other closing surface 26 may help to reduce relative movement between the two. This reduces undesirable production of particles.

In an embodiment, the sealer 27 is configured such that a force resists separation of the members 21 and 24 when the pod 20 is closed. This helps to keep the top member 21 and the opposing bottom member 24 together, particularly during a venting process. This helps to reduce gas flow via the sides of the pod 20 between the top member 21 and the bottom member 24.

In an embodiment, the force that resists separation of the members 21 and 24 is weaker than the strength of attachment between the sealer 27 and the main body 22 of the member 21 to which it is attached. This difference in forces helps to keep the sealer 27 in place during opening of the pod 20. This also helps to reduce the possibility of the pod 20 being stuck closed and difficult to open.

There are various ways of providing a force that resists movement between the members 21 and 24, and/or that resists separation of the members 21 and 24 when the pod 20 is closed. In an embodiment the closing surface 23 formed by the sealer 27 is adhesive. For example, the sealer 27 may have a closing surface 23 that is weakly adhesive. i.e. tacky. Meanwhile, the other side of the sealer 27 may be more strongly adhesive so as to attach firmly to the main body 22.

Figure 3 is a schematic illustration of part of the top member 21 including the sealer 27. As shown in Figure 3, in an embodiment the closing surface 23 formed by the sealer 27 comprises topographical engaging elements 32. The topographical engaging elements 32 are configured to promote intermolecular attraction by van der Waals forces. The engaging elements 32 may be in the form of pillars. The sealer 27 comprises a nanostructured material. The engaging elements 32 increase the potential contact area at the closing surface area 23. For example, Gecko® Nanoplast® may be used for the sealer 27. Such a sealer 27 may be dry and not tacky. This may reduce outgassing from the sealer 27 thereby reducing the production of particles. Otherwise, materials that are tacky may have their tackiness provided by having polymers that are not cross-linked. Although their tackiness may be desirable, the uncrosslinked polymers are more likely to cause outgassing, which is undesirable.

As shown in Figure 3, in an embodiment an adhesive 31 may be used to attach the sealer 27 to the main body 22. In an alternative embodiment, such an adhesive layer 31 may not be required, for example if the sealer 27 itself is adhesive to the main body 22.

Figure 4 is a schematic illustration of part of the top member 21 according to an embodiment of the invention. As shown in Figure 4, in an embodiment the sealer 27 comprises a magnet 41. The magnet may be attached to the rest of the sealer 27 (e.g. to a polymer) by an adhesive layer 31. The adhesive layer 31 and the magnet 41 may be considered as part of the sealer 27. In an embodiment, the magnet 41 may be attached to the main body 22 by an adhesive layer 31. The adhesive layer 31 between the polymer of the sealer 27 and the magnet 41 may not be required, for example, if the sealer 27 is itself adhesive.

The magnet 41 can provide a magnetic force attracting the top member 21 to the bottom member 24. For example, the main body 25 of the bottom member 24 may be formed of a ferrous material such that it is attracted to the magnet 41. In the embodiment shown in Figure 4, the main body 22 could be made of aluminium, for example, with the magnet 41 providing the magnetic force to the bottom plate 24. The main body 25 of the bottom plate 24 could be made of a ferrous material. Alternatively, the main body 25 of the bottom plate 24 could be made of a material such as aluminium and have a strip of a ferrous material or a magnet attached to it. The magnet 41 may help to reduce outgassing from the sealer 27, while providing the function of having a force resisting separation of the top member 21 from the bottom member 24. Meanwhile, the polymer below the magnet 41 (in the orientation shown in Figure 4) provides the softness for conforming to the irregularities in the closing surface 26 of the bottom member 24.

As mentioned above, the sealer 27 may comprise a ribbon of material. In an embodiment, a solid ribbon of material may be applied to the main body 22 of the member 21 to which the sealer 27 is attached. Such a solid ribbon of material (e.g. foil) has good robustness. In particular, it may have high-wear resistance and have low outgassing.

In an alternative embodiment, a liquid polymer may be applied to the main body 22 of the member 21 to which the sealer 27 is to be attached. The polymer is then allowed to dry. The sealer 27 comprises the dried polymer. Such a polymer could be removed as part of a regular cleaning cycle, and then reapplied. Such a polymer could be applied to a pod 27 that has already been manufactured, i.e. as a retrofit. For example, First Contact Polymer™ or Opticlean™ polymer could be used as a liquid polymer that is then dried on the main body 22 to form the sealer 27.

As mentioned above, in an embodiment the closing surface 26 of one of the members 24 is formed of metal. In particular, in an embodiment the closing surface 26 of the bottom member 24 is formed of metal. The bottom member 24 may, in use, remain with the patterning device MA for a longer period of time in the lithographic apparatus compared to the top member 21. It is helpful for the surfaces of the bottom member 24 to have particularly low outgassing, for example, by forming them of metal.

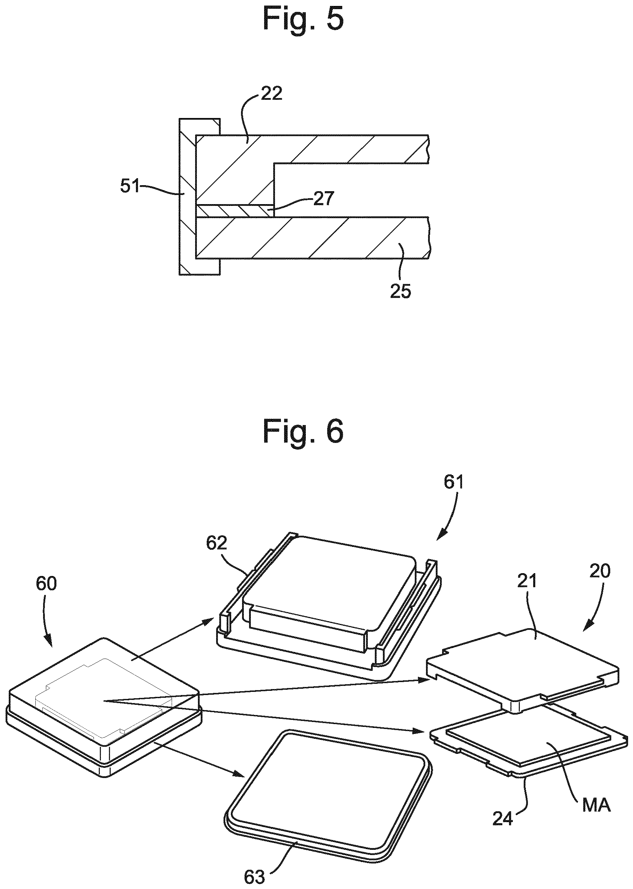

Figure 5 is a schematic illustration of part of a pod 20 according to an embodiment of an invention. As shown in Figure 5, an embodiment of the pod 20 comprises a mechanical lock 51. The mechanical lock 51 is configured to reduce movement between the members 21 and 24 when the pod 20 is closed. For example, as shown in Figure 5, in an embodiment a clamp is provided as the mechanical lock 51. The mechanical lock 41 applies an external force to prevent motion between the main bodies 22 and 25. This helps to prevent undesirable motion between the members 21 and 24, for example, during an earthquake. In an alternative embodiment, a screw may be provided to form the mechanical lock i.e. instead of, or as well as, the clamp. Other types of mechanical lock can be used.

As shown in Figure 2, in an embodiment, the bottom member 24 comprises a window 28. The window 28 is made of a transparent material, for example glass. As shown in Figure 2, a plurality (e.g. two) windows 28 may be provided. The window 28 is configured to allow a measurement beam from below the bottom member 24 to reflect off the patterning device MA when the patterning device MA is on the bottom member 24. Such measurement beams can be used to align the patterning device MA in the lithographic apparatus. The window 28 may be embedded in the main body 25 of the member 24. The size of the window 28 is not particularly limited, but may be of the order of about 10 mm in diameter. The measurement beam can also be used to detect if a filter such as a pellicle is present. The bottom member 24 may then be removed before an exposure process is performed. The size of the patterning device MA is not particularly limited, but may have a side length of about 150 mm.

As shown in Figure 2, in an embodiment one of the members 21 comprises a mesh 29. The mesh 29 is configured to allow gas flow through the member 21 while filtering out particles. The mesh 29 comprises a plurality of holes. Gas can flow through the holes between the interior of the pod 20 and the exterior of the pod 20. The mesh 29 is configured to filter out particles of the order of 5 nm or larger. In an embodiment, the mesh 29 can be replaced. The mesh 29 is embedded in the main body 22 of the top member 21. Although the mesh 29 is shown as being embedded in the top member 21, in an alternative embodiment the mesh 29 may be embedded in the bottom member 24.

As indicated by the arrow 30 in Figure 2, a flow of gas may flow through the mesh 29 from the exterior of the pod 20 to the interior of the pod 20. This may occur when a venting process is performed, for example when transporting from a vacuum to a higher pressure (e.g. atmospheric pressure).

Figure 6 is an illustration of a transport case 60 for the patterning device MA. As shown in Figure 6 in an embodiment the transport case 60 comprises the pod 20 described above. In addition, the transport case 60 comprises an outer pod 61. The outer pod 61 is configured to close around the inner pod 20. As shown in Figure 6 in an embodiment the outer pod 61 comprises a top part 62 and a bottom part 63 that can enclose around the inner pod 20. The outer pod 61 is used primarily for transport and storage of the patterning device MA. The outer pod 61 is configured to shield the inner pod 20 from human touch and ambient contamination. In use, the outer pod 61 does not enter into the vacuum environment of the lithographic apparatus. The outer pod 61 is intended to be used only outside of the lithographic apparatus. In contrast, the inner pod 20 enters into the vacuum environment of the lithographic apparatus. Accordingly, there is a greater requirement for the inner pod 20 to remain clean than for the outer pod 61.

In use, the outer pod 61 may be loaded onto a patterning device loading bay. This may be done by hand. Alternatively, this may be done by an automated (overhead) delivery system. The outer pod 61 is opened. The inner pod 20 is removed from the outer pod 61. The pressure is reduced towards a vacuum pressure. The pod 20 is then stored in a vacuum library. For exposures, the top member 21 is removed from the pod 20. The top member 21 may remain in the library. The patterning device MA on the bottom member 24 is moved to an exposure clamp. The exposure clamp is configured to hold the patterning device MA in pace during an exposure. When the exposure clamp holds the patterning device MA, the bottom member 24 is removed from the patterning device MA. The patterning device MA held by the clamp is then aligned, and then an exposure process is performed.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

The term "EUV radiation" may be considered to encompass electromagnetic radiation having a wavelength within the range of 4-20 nm, for example within the range of 13-14 nm. EUV radiation may have a wavelength of less than 10 nm, for example within the range of 4-10 nm such as 6.7 nm or 6.8 nm.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A pod for housing a patterning device for EUV lithography, the pod comprising:
a top member and an opposing bottom member each comprising a main body of a first material and a closing surface configured to contact the closing surface of the other member so as to close the pod around a patterning device,
wherein the closing surface of one of the members is formed by a sealer of a second material different from the first material and configured to conform to the closing surface of the other member.

2. The pod of claim 1, wherein each main body is metal and the sealer is non-metal.

3. The pod of claim 1, wherein the sealer comprises a ribbon of material attached to the main body of the member.

4. The pod of any preceding claim, wherein the sealer is detachable from and attachable to the main body.

5. The pod of any preceding claim, wherein the sealer is configured such that a force resists separation of the members when the pod is closed.

6. The pod of claim 5, wherein the sealer is configured such that the force is weaker than a strength of attachment between the sealer and the main body of the member.

7. The pod of claim 5 or 6, wherein the closing surface formed by the sealer is adhesive.

8. The pod of any of claims 5 to 7, wherein the closing surface formed by the sealer comprises topographical engaging elements configured to promote intermolecular attraction by van der Waals' force.

9. The pod of any of claims 5 to 8, wherein the sealer comprises a magnet.

10. The pod of any of any preceding claim, wherein the closing surface formed by the sealer is formed of a polymer.

11. The pod of claim 10, wherein the polymer is selected from a group consisting of polyimide, PTFE and silicone.

12. The pod of any of claims 1 to 9, wherein the sealer comprises a diamond-like carbon coating that forms the closing surface.

13. The pod of any preceding claim, wherein the closing surface of one of the members is formed of the first material.

14. The pod of any preceding claim, wherein the closing surface of the bottom member is formed of the first material.

15. The pod of any preceding claim, comprising a mechanical lock configured to reduce movement between the members when the pod is closed.

16. The pod of claim 15, wherein the mechanical lock is selected from a group consisting of a clamp and a screw.

17. The pod of any preceding claim, wherein the bottom member comprises a window for allowing a measurement beam from below the bottom member to reflect off the patterning device when it is on the bottom member.

18. The pod of any preceding claim, wherein at least one of the members comprises a mesh configured to allow gas to flow through the member while filtering out particles.

19. A transport case for a patterning device for EUV lithography, the transport case comprising:
the pod of any preceding claim as an inner pod; and
an outer pod configured to close around the inner pod.

20. A patterning device assembly comprising:
the pod of any of claims 1 to 18 or the transport case of claim 19; and
a patterning device for EUV lithography.

21. A method of manufacturing a pod for housing a patterning device for EUV lithography, the method comprising:
providing a top member and an opposing bottom member each comprising a main body of a first material and a closing surface configured to contact the closing surface of the other member so as to close the pod around a patterning device,
wherein the closing surface of one of the members is formed by a sealer of a second material different from the first material configured to conform to the closing surface of the other member.

22. The method of claim 21, comprising:
applying a solid ribbon of material to the main body of the member, wherein the sealer comprises the ribbon of material.

23. The method of claim 21, comprising:
applying a liquid polymer to the main body of the member; and
allowing the polymer to dry, wherein the sealer comprises the dried polymer.
